# EUROPEAN PATENT SPECIFICATION

(11) **EP 0 257 553 B1**
(45) Date of publication and mention of the grant of the patent: **26.05.1993**
(21) Application number: 87112051.5
(22) Date of filing: 19.08.1987
(51) Int. Cl.: H05K 13/08, H05K 13/04, H01L 21/00

(54) **Apparatus for detecting a position of an electronic part**
Gerät zum Feststellen der räumlichen Anordnung eines elektronischen Bauteils
Appareil pour la détection de la position d'un composant électronique

(30) Priority: 22.08.1986 JP 197907/86
(43) Date of publication of application: 02.03.1988
(73) Proprietor: SANYO ELECTRIC CO., LTD., Moriguchi-shi, Osaka 570 (JP)
(72) Inventor: Masayuki, Mohara, Ora-gun, Gunma-ken, (JP)
(74) Representative: Twelmeier, Ulrich, Dipl.Phys.

(56) References cited:
- EP-A- 0 066 631
- DE-A- 1 925 215
- DE-A- 2 643 810
- US-A- 4 608 494
- IBM TECHNICAL DISCLOSURE BULLETIN, vol. 24, no. 6, November 1981, page 2937, New York, US; D.S. EHN et al.: "Diffuser for back-light panels"
- ELEKTROTECHNIK, vol. 65, no. 20, Oktober 1983, pages 76,77, Würzburg, DE; "Oberflächlich montiert"

## Description

The present invention relates to an apparatus for detecting a position of an electronic part for correcting a relavtive position between the electronic part and a print substrate on which the elcetronic part is to be mounted, whereby the correction takes place on the basis of the result of detection, the apparatus comprising attraction means for attracting and holding said electronic part, at least one first light source for giving light onto the electronic part, and imaging means for detecting the position of the electronic part.

Such a device is known from the document "ELEKTROTECHNIK, VL 65, NO.20, Oktober 1983, pages 76 and 77".

This device can detect the position of an electronic part. The light from a light source, positioned beneath a substrate, is irradiated onto the substrate so that the metallic sections of the substrate are displayed, via a video camera, on a screen. When the substrate is irradiated, the electronic part, positioned near the substrate for mounting, is also illuminated so that its outline together with the structure of the electric conductors on the substrate are depicted on the screen. The part is then arranged in relation to the electric conductors of the substrate in order to achieve an exact mounting. Thus the detecting principle occurs during the mounting of the electronic part on the substrate.

This device is not able to correctly detect the position of electronic parts having no protruded or projected terminal pins such as LSI called LCC (Leadless Chip Carrier) or PLCC (Plastic Leadless Chip Carrier). Therefore, it is difficult to perform detection of position, which produces a disadvantage in that a lead terminal cannot be subjected to imaging.

It is therefore an object of the present invention to provide an apparatus for detecting a position of an electronic part of the above mentioned art being able to detect the position of an electronic part even said electronic part has no protruding terminal pins and correcting this position for mounting on a print substrate being made of a material having no light transmitting capacity.

This object is solved according to the invention by providing an apparatus for detecting a position of an electronic part for correcting a relative position between the electronic part and a print substrate on which the electronic part is to be mounted, whereby the correction takes place on the basis of the result of detection, the apparatus comprising attraction means for attracting and holding said part, at least one first light source for giving light onto the electronic part, and imaging means for detecting the position of the electronic part, whereby according to the invention a light diffusion plate for diffusing light from the first light source is disposed above a low-end portion of the attraction means and gives light indirectly onto the top and beyond the circumference of the electronic part for providing a silhouette image, a second light source is disposed below the low-end portion of the attraction means, whereby the imaging means are disposed below the electronic part to be held by the attraction means, and the light produced by the first light source is indirectly given onto the top and beyond the circumference of the electronic part through the light diffusion plate and the light transmitted past the circumferential portion of the electronic part is applied to the imaging means or the light produced by the second light source is given onto the bottom surface of the electronic part and reflected light from the bottom surface of the electronic part is applied to the imaging means.

A second embodiment of the invention is described in claim 3. In the present invention, the light sources are suitably switched according to the state whether or not the terminal pin is protruded from the package body as in electronic parts, particularly LSI or LCC, and an image may be obtained by the imaging device.

The imaging means and the attracting means occupy different working spaces in the invention. The freedom of movement of the movable attracting means is therefore not restricted by the imaging means. According to the invention, the imaging means register the outline or the structure of the electronic part from below. This means that the terminals of the electronic part, necessary for the later mounting on the substrate, are registered from the bottom side.
FIGS. 1 and 2 are respectively front views of essential parts showing one embodiment of an apparatus for detecting a position of an electronic part according to the present invention;
FIGS. 3 and 4 are respectively front views of essential parts showing a further embodiment of the present invention;
FIGS. 5 and 6 illustrate the imaging state in FIGS. 1 and 3; and
FIGS. 7 (a) and (b) are perspective views of QFP and LCC, respectively, which are electronic parts.

### DESCRIPTION OF THE PREFERRED EMBODIMENTS

In the drawings, the same elements as those described in connection with the aforementioned prior art are indicated by the same reference numerals. Reference numeral 5 designates an attraction nozzle for attracting and transferring an electronic part; 6, a first light source; 7, an upper diffusion plate; 8, a second light source; 9, a lower diffusion plate; 10, an imaging means having a lens 11; and 12, an XY moving head having the attraction nozzle.

The above-described upper diffusion plate 7 and lower diffusion plate 9 are formed, for example, from frosted glass which generates scattered light at the surface portion, or an indirect illumination member formed of a polyacetal resin which generates scattered light internally.

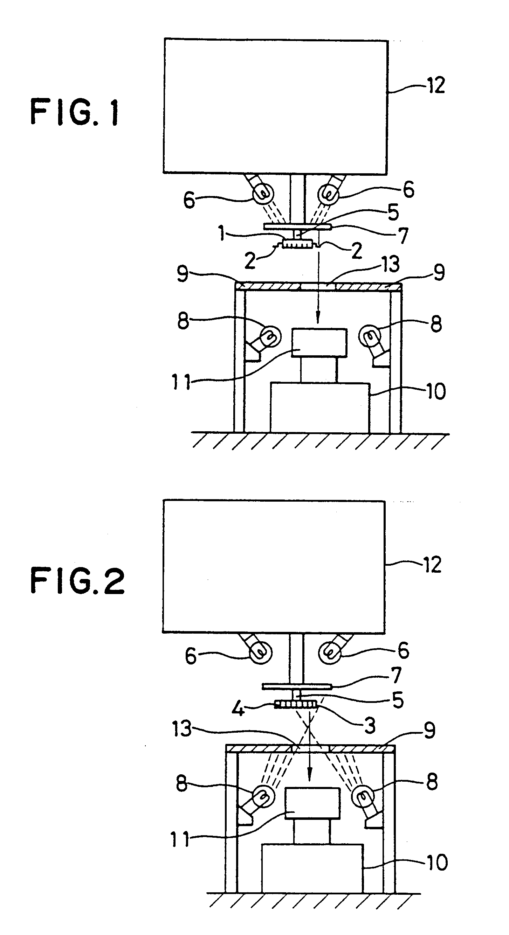

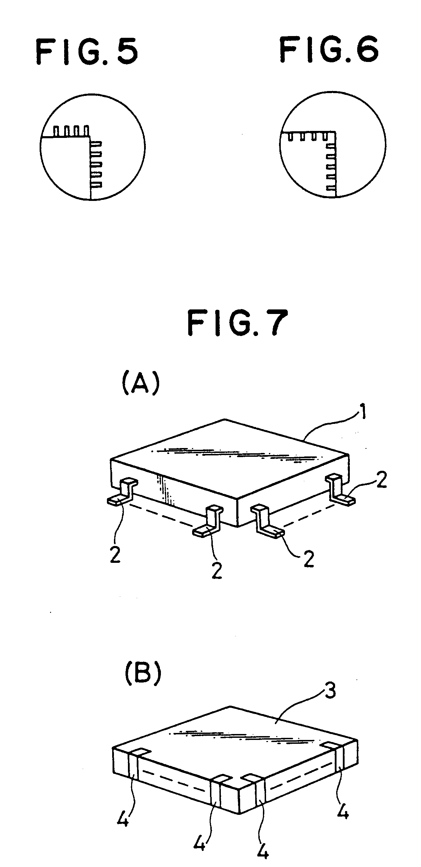

The operation of the apparatus according to the present invention will now be described with reference to FIGS. 1 and 2. First, in the case of QFP (Quad Flat Package) type IC (hereinafter referred to as QFP) in which a terminal pin 2 is projected (overflows) from a package body 1, for example, when the QFP is removed out of a stick (not shown) and thereafter the QFP as an electronic part is attracted by the attraction nozzle 5, the first light sources 6 are turned on as shown in FIG. 1 to irradiate light on the upper diffusion plate 7. Thereby the terminal pin 2 of the QFP is irradiated through a through-hole 13 of the lower diffusion plate 9, the transmission light moves downward as indicated by the arrow to reach the imaging means 10, and an image caused by the transmission light is obtained, assuming the state view shown in FIG. 5.

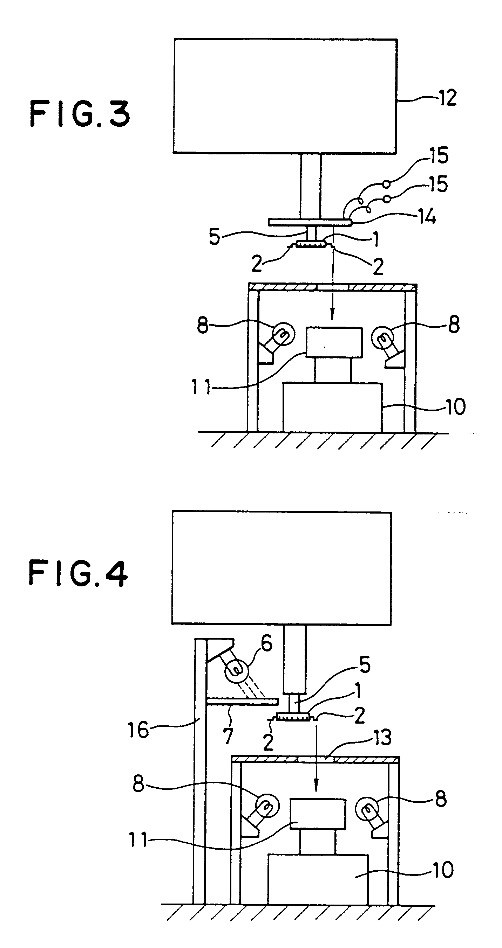

On the other hand, in the case of the LSI (hereinafter referred to as LCC) of the type called LCC (Leadless Chip Carrier) or PLCC (Plastic Leadless Chip Carrier), when the LCC is removed out of a stick and thereafter the package body 1 of LCC is attracted by the attraction nozzle 5, in a manner similar to the former, the second light sources 8 are turned on as shown in FIG. 2 whereby the terminal pin 3 of LCC is irradiated by the light from the through-hole 13 of the lower diffusion plate 9, and the reflected light reaches the imaging means 10. The image caused by the imaging means 10 assumes the state view as shown in FIG. 4.

FIG. 3 shows an example which uses an electro-luminescence (merely referred to as EL) in place of the upper diffusion plate and the first light sources in the embodiments shown in FIGS. 1 and 2. In FIG. 3, when the position detection of the terminal pin 3 of QFP is carried out, a voltage is applied to terminals 15 and 15 of the EL 14 to irradiate the light on the terminal pin 2 of the QFP, and an image caused by the irradiated light is imaged by the imaging means 10 through a through-hole 13. Then the respective terminal pins of the QFP may be detected in position in the manner similar to that shown in FIG. 1.

According to another embodiment, when the first light source 6 and the upper diffusion plate 7 are mounted on a support leg 16, when the terminal pin 2 of the QFP is imaged likewise the FIG. 1 embodiment, the light is irradiated thereon by the first light source 6 through the upper diffusion plate 7 to effect the position detection with the transmission light. In this case, the image plane caused by the imaging means assumes the state view shown in FIG. 6.

It is noted in FIG. 3 as well as FIG. 4 that when the position detection of LCC is effected, the light from the second light sources 8 is irradiated on the package body 3 of LCC from the bottom, and the reflected light having passed through the through-hole 13 reaches the imaging means 10, similarly to the FIG. 2 embodiment.

The QFP, LCC, etc. as the electronic parts are mounted in place on the print substrate (not shown) through the above-described position detection process, and the position detection in a state of being attracted by the attraction nozzle 5 is carried out accurately. For example, a computer which stores a normal attracted position reads a deviation between the normal attracted position and a detected position, and the attraction nozzle is displaced through the deviation to mount an electronic part on a print substrate or a table on which a print substrate is disposed is moved through the deviation, after which an electronic part is mounted, then the precision of mounting electronic parts may be enhanced.

According to the apparatus for detecting a position of an electronic part of the present invention, the terminal pins of the leadless type LSI called LCC or PLCC which has many terminal pins and has been considered to be very difficult in detection, may be detected by the reflected light. In addition, an LC of the QFP type in which a terminal pin is protruded from a package body may be position-detected by the transmission light. Furthermore, position detections of electronic parts of either type of IC in which a terminal pin is protruded from a package body or a type in which a terminal pin is not projected therefrom can be selectively carried out. For this reason, the range of use of the apparatus may be extended. Therefore, the detection operation is easy, which leads to the enhancement of mounting accuracy in the after-mounting process. Thus, the present is advantageously utilized for a position detector in automatic mounting or automatic insertion of electronic parts.

## Claims

1. Apparatus for detecting a position of an electronic part (1) for correcting a relative position between the electronic part (1) and a print substrate on which the electronic part (1) is to be mounted, whereby the correction takes place on the basis of the result of detection, the apparatus comprising attraction means (5) for attracting and holding said electronic part (1); at least one first light source (6) for giving light onto the electronic part (1); and imaging means (10, 11) for detecting the position of the electronic part (1), **characterized** in that a light diffusion plate (7) for diffusing light from the first light source (6) is disposed above a low-end portion of the attraction means (5) and gives light indirectly onto the top and beyond the circumference of the electronic part (1) for providing a silhouette image, that a second light source (8) is disposed below the low-end portion of the attraction means (5), that the imaging means (10, 11) are disposed below the electronic part (1) to be held by the attraction means (5), that the light produced by the first light source (6) is indirectly given onto the top and beyond the circumference of the electronic part (1) through the light diffusion plate (7) and the light transmitted past the circumferential portion of the electronic part (1) is applied to the imaging means (10, 11), or the light produced by the second light source (8) is given onto the bottom surface of the electronic part (1) and reflected light from the bottom surface of the electronic part (1) is applied to the imaging means (10, 11).

2. Apparatus according to claim 1, **characterized** by a support leg (16) on which the first light source (6) and said diffusing plate (7) are mounted.

3. Apparatus for detecting a position of an electronic part (1) for correcting a relative position between the electronic part (1) and a print substrate on which the electronic part (1) is to be mounted, whereby the correction takes place on the basis of the result of detection, the apparatus comprising attraction means (5) for attracting and holding said electronic part (1); at least one first light source (14) for giving light onto the electronic part (1); and imaging means (10, 11) for detecting the position of the electronic part (1), **characterized** in that the first light source (14) with a luminous plane face is disposed above a low-end portion of the attraction means (5) and gives light directly onto the top and beyond the circumference of the electronic part (1) for providing a silhouette image, that a second light source (8) is disposed below the low-end portion of the attraction means (5), that the imaging means (10, 11) are disposed below the electronic part (1) to be held by the attraction means (5), that the light produced by the first light source (6, 14) is directly given onto the top and beyond the circumference of the electronic part (1) and the light transmitted past the circumferential portion of the electronic part (1) is applied to the imaging means (10, 11), or the light produced by the second light source (8) is given onto the bottom surface of the electronic part (1) and reflected light from the bottom surface of the electronic part (1) is applied to the imaging means (10, 11).

4. Apparatus according to claim 3, **characterized** in that the first light source comprises an electroluminescent plate (14).

5. Apparatus according to any one of claims 1 to 4, **characterized** in that a diffusing plate (9) is disposed between the second light source (8) and the electronic part (1), the diffusing plate (9) having a light transparent area (13), that the imaging means (11) are disposed below the diffusing plate (9), that the light produced by the second light source (8) being irradiated onto the bottom surface of the electronic part (1) through the diffusing plate (9) and reflected light from the bottom surface of the electronic part (1) is applied to the imaging means (10, 11) through the transparent area (13) of the diffusing plate (9).

## Patentansprüche

1. Vorrichtung zum Erfassen der Position eines elektronischen Bauteiles (1) zum Korrigieren einer relativen Position zwischen dem elektronischen Bauteil (1) und einer Leiterplatte, auf welcher das elektronische Bauteil (1) montiert werden soll, wobei die Korrektur auf der Basis des Erfassungsergebnisses erfolgt und wobei die Vorrichtung eine Aufnahmevorrichtung (5) zum Aufnehmen und Halten des elektronischen Bauteiles (1), mindestens eine erste Lichtquelle (6) zur Abgabe von Licht auf das elektronische Bauteil (1) und eine Abbildungseinrichtung (10, 11) zum Erfassen der Position des elektronischen Bauteils (1) umfaßt, dadurch **gekennzeichnet,** daß eine Lichtstreuplatte (7) zum Streuen des von der ersten Lichtquelle (6) kommenden Lichtes oberhalb eines unteren Endabschnittes der Aufnahmevorrichtung (5) angeordnet ist und Licht indirekt auf die Oberseite des elektronischen Bauteils (1) und über dessen Umfang hinaus abgibt, um ein Silhouettenbild zu erzeugen, daß eine zweite Lichtquelle (8) unterhalb des unteren Endabschnittes der Aufnahmeeinrichtung (5) angeordnet ist, daß die Abbildungseinrichtung (10, 11) unterhalb des von der Aufnahmeeinrichtung (5) zu haltenden elektronischen Bauteiles (1) angeordnet ist, daß das von der ersten Lichtquelle (6) erzeugte Licht durch die Lichtstreuplatte (7) indirekt auf die Oberseite des elektronischen Bauteiles (1) und über dessen Umfang hinaus abgegeben wird und daß das an dem Umfangsabschnitt des elektronischen Bauteiles (1) vorbei übertragene Licht der Abbildungseinrichtung (10, 11) zugeführt wird oder daß das von der zweiten Lichtquelle (8) erzeugte Licht auf die Unterseite des elektronischen Bauteils (1) ausgesandt wird und das von der Unterseite des elektronischen Bauteils (1) reflektierte Licht der Abbildungseinrichtung (10, 11) zugeführt wird.

2. Vorrichtung nach Anspruch 1, **gekennzeichnet** durch einen Stützfuß (16), an dem die erste Lichtquelle (6) und die Streuplatte (7) angeordnet sind.

3. Vorrichtung zum Erfassen einer Position eines elektronischen Bauteiles (1) zum Korrigieren einer relativen Position zwischen dem elektronischen Bauteil (1) und einer Leiterplatte, auf der das elektronische Bauteil (1) montiert werden soll, wobei die Korrektur auf der Basis des Erfassungsresultates erfolgt und wobei die Vorrichtung eine Aufnahmeeinrichtung (5) zum Aufnehmen und Halten des elektronischen Bauteils (1), mindestens eine erste Lichtquelle (14) zur Abgabe von Licht auf das elektronische Bauteil (1) und eine Abbildungseinrichtung (10, 11) zum Erfassen der Position des elektronischen Bauteils (1) umfaßt, dadurch **gekennzeichnet,** daß die erste Lichtquelle (14) mit einer ebenen Leuchtfläche oberhalb eines unteren Endabschnittes der Aufnahmeeinrichtung (5) angeordnet ist und Licht direkt auf die Oberseite und über den Umfang des elektronischen Bauteils (1) abgibt, um ein Silhouettenbild zu erzeugen, daß eine zweite Lichtquelle (8) unterhalb des unteren Endabschnittes der Aufnahmeeinrichtung (5) angeordnet ist, daß die Abbildungseinrichtung (10, 11) unterhalb des von der Aufnahmeeinrichtung (5) zu haltenden elektronischen Bauteils (1) angeordnet ist, daß das von der ersten Lichtquelle (6, 14) erzeugte Licht direkt auf die Oberseite und über den Umfang des elektronischen Bauteils (1) hinaus abgegeben wird und daß das an dem Umfangsabschnitt des elektronischen Bauteils (1) vorbei übertragene Licht der Abbildungseinrichtung (10, 11) zugeführt wird oder daß das von der zweiten Lichtquelle (8) erzeugte Licht auf die Unterseite des elektronischen Bauteils (1) abgegeben und das von der Unterseite des elektronischen Bauteils (1) reflektierte Licht der Abbildungseinrichtung (10, 11) zugeführt wird.

4. Vorrichtung nach Anspruch 3, dadurch **gekennzeichnet**, daß die erste Lichtquelle eine elektroluminiszente Platte (14) umfaßt.

5. Vorrichtung nach einem der Ansprüche 1 bis 4, dadurch **gekennzeichnet,** daß eine Streuplatte (9) zwischen der zweiten Lichtquelle (8) und dem elektronischen Bauteil (1) angeordnet ist, daß die Streuplatte (9) einen transparenten Bereich (13) hat, daß die Abbildungseinrichtung (11) unterhalb der Streuplatte (9) angeordnet ist, daß das von der zweiten Lichtquelle (8) erzeugte Licht auf die Unterseite des elektronischen Bauteils (1) durch die Streuplatte (9) hindurch ausgesandt wird und daß das von der Unterseite des elektronischen Bauteils (1) reflektierte Licht der Abbildungseinrichtung (10, 11) durch den transparenten Bereich (13) der Streuplatte (9) hindurch zugeführt wird.

## Revendications

1. Appareil pour détecter la position d'un composant électronique (1) pour corriger une position relative entre ce composant (1) et un substrat imprimé sur lequel on doit monter le composant électronique (1), la correction s'effectuant sur la base du résultat de la détection, l'appareil comprenant des moyens d'attraction (5) pour attirer et tenir le composant électronique (1), au moins une première source de lumière (6) pour envoyer de la lumière sur ledit composant (1), et des moyens de représentation (10,11) pour détecter la position de ce composant électronique (1), caractérisé en ce qu'une plaque de diffusion de la lumière (7) pour diffuser la lumière en provenance de la première source de lumière (6) est disposée au-dessus de la portion terminale inférieure des moyens d'attraction (5) et l'applique indirectement sur la surface supérieure du composant électronique (1) et l'envoie au-delà de sa circonférence pour procurer une image silhouette, en ce qu'une deuxième source de lumière (8) est disposée en dessous de la portion terminale inférieure des moyens d'attraction (5), en ce que les moyens de représentation (10,11) sont disposés en dessous du composant électronique (1) tenu par les moyens d'attraction (5), en ce que la lumière émise par la première source de lumière (6) est indirectement appliquée sur la surface supérieure du composant électronique (1) et envoyée au-delà de sa circonférence par l'intermédiaire de la plaque de diffusion de la lumière (7) et en ce que la lumière transmise au-delà de la portion circonférentielle du composant (1) est appliquée sur les moyens de représentation (10,11), ou bien en ce que la lumière émise par la deuxième source de lumière (8) est envoyée sur la surface inférieure du composant électronique (1) et en ce que la lumière réfléchie par cette surface inférieure du composant (1) est appliquée sur les moyens de représentation (10,11).

2. Appareil selon la revendication 1, caractérisé par un pied support (16) sur lequel sont montées la première source de lumière (6) et la plaque de diffusion (7).

3. Appareil pour détecter la position d'un composant électronique (1) pour corriger une position relative entre ce composant (1) et un substrat imprimé sur lequel on doit monter le composant électronique (1), la correction s'effectuant sur la base du résultat de la détection, l'appareil comprenant des moyens d'attraction (5) pour attirer et tenir le composant électronique (1), au moins une première source de lumière (14) pour envoyer de la lumière sur ledit composant (1), et des moyens de représentation (10,11) pour détecter la position de ce composant électronique (1), caractérisé en ce que la première source de lumière (14) avec une face plane lumineuse est disposée au-dessus de la portion terminale inférieure des moyens d'attraction (5) et applique directement la lumière sur la surface supérieure du composant électronique (1) et l'envoie au-delà de sa circonférence pour procurer une image silhouette, en ce qu'une deuxième source de lumière (8) est disposée en dessous de la portion terminale inférieure des moyens d'attraction (5), en ce que les moyens de représentation (10,11) sont disposés en dessous du composant électronique (1) tenu par les moyens d'attraction (5), en ce que la lumière émise par la première source de lumière (6,14) est directement appliquée sur la surface supérieure du composant électronique (1) et envoyée au-delà de sa circonférence et en ce que la lumière transmise au-delà de la portion circonférentielle du composant (1) est appliquée sur les moyens de représentation (10,11), ou bien en ce que la lumière émise par la deuxième source de lumière (8) est envoyée sur la surface inférieure du composant électronique (1) et en ce que la lumière réfléchie par cette surface inférieure du composant (1) est appliquée sur les moyens de représentation (10,11).

4. Appareil selon la revendication 3, caractérisé en ce que la première source de lumière comprend une plaque électroluminescente (14).

5. Appareil selon l'une des revendications 1 à 4, caractérisé en ce qu'une plaque diffusante (9) est disposée entre la deuxième source de lumière (8) et le composant électronique (1), la plaque diffusante (9) ayant une zone photo-transparente (13), en ce que les moyens de représentation (11) sont disposés en dessous de la plaque diffusante (9), en ce que la lumière émise par la deuxième source de lumière (8) envoyée sur la surface inférieure du composant électronique (1) à travers la plaque diffusante (9) et réfléchie par cette surface inférieure du composant (1) est appliquée sur les moyens de représentation (10,11) à travers cette zone transparente (13) de la plaque diffusante (9).
